# EUROPEAN PATENT APPLICATION

(11) **EP 4 485 804 A1**
(43) Date of publication of application: **01.01.2025**
(21) Application number: 23759859.4
(22) Date of filing: 16.02.2023
(51) Int. Cl.: H03M 1/10, H02P 29/024

(54) **SIGNAL PROCESSING DEVICE AND PROGRAM**

(30) Priority: 22.02.2022 JP 2022025609
(71) Applicant: DENSO CORPORATION, Kariya-city, Aichi 448-8661 (JP)
(72) Inventor: ISHIKAWA, Akeru, Kariya-city, Aichi 448-8661 (JP); YAMAMURA, Masanori, Kariya-city, Aichi 448-8661 (JP)
(74) Representative: Kuhnen & Wacker Patent- und Rechtsanwaltsbüro PartG mbB
(86) International application number: PCT/JP2023/005536
(87) International publication number: WO 2023/162858

(57) **Abstract**

This signal processing device (301-306) performs AD conversion on sensor signals inputted from electric current sensors (71, 72, 73) provided to N (≥ 3) electric current paths (81, 82, 83) connected at a connection point (P) of a closed circuit, and outputs the resultant sensor signals as converted signals. Two to N AD converters (31, 32, 33) that are provided independently from each other have at least one channel to which a sensor signal is inputted. For the converted signals outputted by the AD converters, an anomaly determination unit (40) calculates an electric current sum value that is the sum of N converted signals corresponding to electric currents flowing in and out of the connection point (P), and, if the absolute value of the electric current sum value is greater than a determination threshold, determines that there is an anomaly in a channel of the one of the AD converters. In the two to N AD converters, the total number of channels to which the sensor signals are inputted is N to (2N -1).

## Description

### CROSS REFERENCE TO RELATED APPLICATIONS

The present application claims the benefit of priority from Japanese Patent Application No. 2022-025609 filed on February 22, 2022. The entire disclosures of all of the above applications are incorporated herein by reference.

### TECHNICAL FIELD

The present disclosure relates to a signal processing device and a program.

### BACKGROUND ART

Conventionally, a technique of detecting a failure in an AD converter in a signal processing device for AD converting an input signal is known. For example, Patent Literature 1 discloses a failure detecting method of redundantly inputting the same analog signal to two independent AD converters, determining a normal state when digital data output from the AD converters is equal, and determining an abnormal state when the digital data is not equal.

### PRIOR ART LITERATURE

### PATENT LITERATURE

Patent Literature 1: JP 2000-151405 A

### SUMMARY OF INVENTION

For example, in the case of applying the conventional technique of the Patent Literature 1 to a signal processing device to which signals of current sensors provided for current paths of three phases of a three-phase motor are input, since the sensor signals of three phases are input to each of two AD converters, total six channels are necessary. Generally, for N kinds of input signals, the necessary total channel number is 2N in the conventional technique of the Patent Literature 1, so the number of parts and the number of wiring processes increase.

An object of the present disclosure is to provide a signal processing device and program determining an abnormality in an AD converter while reducing the total number of channels in a signal processing device which AD converts a sensor signal of current flowing in and out of a connection point of a closed circuit.

A signal processing device according to the present disclosure analog-to-digital converts a plurality of sensor signals input from current sensors provided for N pieces (N denotes an integer of three or more) of current paths connected to a connection point of a closed circuit, and outputs the resultant signals as converted signals. For example, sensor signals of phase currents are input to the signal processing device from current sensors installed in the U-phase, V-phase, and W-phase current paths connected to the neutral point of a Y connection 3-phase motor.

The signal processing device includes two to N pieces of AD converters provided independently of one another and an abnormality determination unit. To provide two to N pieces of AD converters provided independently of one another is the minimum prerequisite from the viewpoint of ensuring reliability equivalent to or better than the conventional technology of the Patent Literature 1. Each of the AD converters has at least one channel to which the sensor signal is input.

The abnormality determination unit calculates a current sum value as a sum of the N pieces of the converted signals corresponding to currents flowing in and out of the connection point with respect to the converted signals output from the AD converters and, when an absolute value of the current sum value is greater than a determination threshold, determines that any of channels of any of the AD converters is abnormal.

In two to N pieces of AD converters, the total number of channels to which sensor signals are input is N to (2N-1). To each of the AD converters, at least one kind of a sensor signal out of N kinds of sensor signals output from current sensors is input. That is, even if there is an input signal for another use, by excluding it, there is no AD converter to which a sensor signal input from a current sensor as a target of the disclosure is not input.

Since the sum of currents flowing in and out of the connection point of a closed circuit is zero according to the Kirchhoff law, when a current sum value as the sum of N pieces of converted signals is larger than a determ ination threshold, it can be determ ined that a conversion signal of any of channels in any of the AD converters is abnormal. The determination threshold is set to the upper limit value of the absolute value in the range which is substantially regarded as zero in consideration of variation in current detection and variation.

In the present disclosure, an abnormality in an AD converter can be determined with N to (2N-1) channels as the total number of channels which is smaller than 2N in the conventional technique. Accordingly, the number of parts and the number of wiring processes can be reduced. By comparing current sum values calculated by a plurality of combinations using converted signals by (N+1) to (2N-1) channels, a channel of an AD converter which is abnormal can be estimated.

The present disclosure also provides a program making a signal processing device determine which channel in which AD converter is abnormal. The program produces effects similar to those of the signal processing device.

### BRIEF DESCRIPTION OF THE DRAWINGS

The above and other objects, features and advantages of the present disclosure will become more apparent from the following detailed description made with reference to the accompanying drawings. In the drawings:
FIG. 1 is a configuration diagram of a motor drive system to which a signal processing device of a first embodiment is applied;
FIG. 2 is a block diagram of the signal processing device of the first embodiment;
FIG. 3 is a time chart illustrating a phase current sum value in a normal time;
FIG. 4 is a time chart (1) illustrating a phase current sum value in an abnormal time of an Iw channel of a second AD converter;
FIG. 5 is a time chart (2) illustrating a phase current sum value in an abnormal time of an Iw channel of the second AD converter;
FIG. 6 is a flowchart of AD converter abnormality determining process according to the first embodiment;
FIG. 7 is a block diagram of the signal processing device of a second embodiment;
FIG. 8 is a flowchart of AD converter abnormality determining process according to the second embodiment;
FIG. 9 is a block diagram of the signal processing device of a third embodiment;
FIG. 10 is a flowchart of AD converter abnormality determining process according to the third embodiment;
FIG. 11 is a sub-flowchart 1 of discriminating process in FIG. 10;
FIG. 12 is a sub-flowchart 2 of discriminating process in FIG. 10;
FIG. 13 is a block diagram of the signal processing device of a fourth embodiment;
FIG. 14 is a block diagram of the signal processing device of a fifth embodiment;
FIG. 15 is a block diagram of the signal processing device of a sixth embodiment; and
FIG. 16 is a block diagram of a signal processing device of a comparative example.

### DESCRIPTION OF EMBODIMENTS

Signal processing devices and programs according to a plurality of embodiments will be described with reference to the diagrams. The following first to sixth embodiments will be collectively called "the present embodiment". A signal processing device of the present embodiment is applied to a drive system of a 3-phase motor. The signal processing device performs analog-to-digital conversion (hereinafter, "AD conversion") on three kinds of sensor signals input from three current sensors provided for current paths of the phases and outputs resultant signals as converted signals.

### (System Configuration)

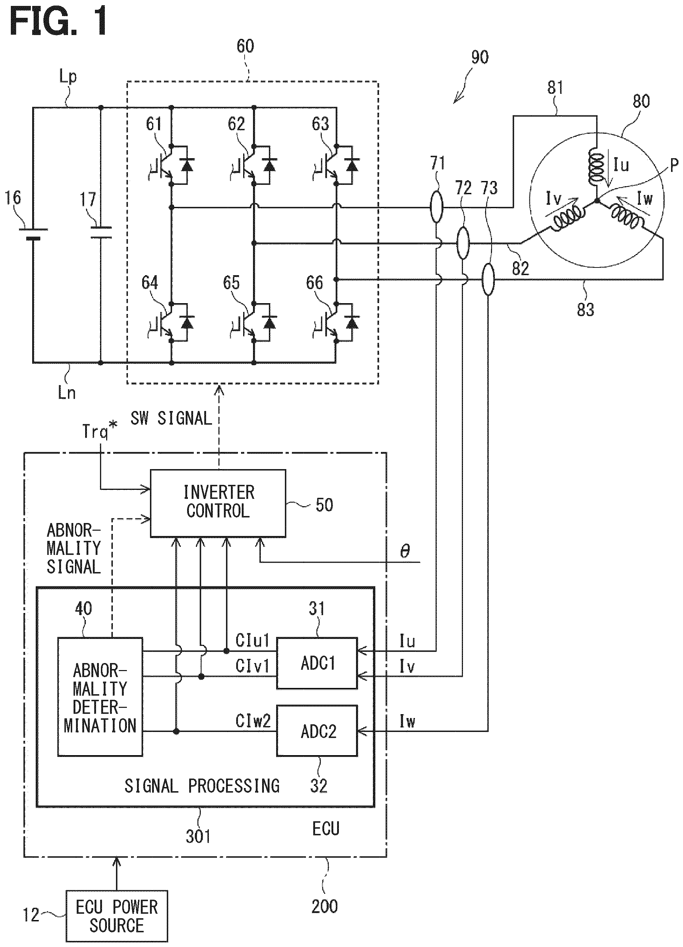

First, referring to FIG. 1, the general configuration of a motor drive system 90 to which the signal processing device of each of the embodiments is applied will be described. FIG. 1 illustrates the configuration of a signal processing device 301 of a first embodiment as a representative. For example, the motor drive system 90 is a system for driving a permanent magnet synchronous 3-phase AC motor 80 used as a main motor of a hybrid vehicle. The motor drive system 90 drives the motor 80 by converting DC power of a high-voltage battery 16 to 3-phase AC power by an inverter 60 and passing the 3-phase AC power from the inverter 60 to the motor 80.

In the inverter 60, six switching elements 61 to 66 of upper and lower arms are bridge-connected. Specifically, the switching elements 61, 62, and 63 are switching elements of the upper arm of U phase, V phase, and W phase, respectively. The switching elements 64, 65, and 66 are switching elements of the lower arm of U phase, V phase, and W phase, respectively. The switching elements 61 to 66 are, for example, configured by IGBTs, and flywheel diodes which permit current flowing from the low-potential side to the high-potential side are connected in parallel.

The inverter 60 converts the DC power to the 3-phase AC power when the switching elements 61 to 66 operate according to a switching signal ("SW signal" in the diagram) generated by an inverter control device 50 in an ECU 200, and passes the 3-phase AC power to windings 81, 82, and 83 of the respective phases. On the battery 16 side of the inverter 60, a capacitor 16 for smoothing input voltage is provided.

Current sensors 71, 72, and 73 are provided for current paths 81, 82, and 83, respectively, which are connected to the windings of the respective phases of the motor 80, and detect phase currents passed to the windings 81, 82, and 83. The current sensor 71 detects a U-phase current Iu, the current sensor 72 detects a V-phase current Iv, and the current sensor 73 detects a W-phase current Iw. The current sensors 71, 72, and 73 output the detected currents as the sensor signals Iu, Iv, and Iw to the signal processing device 301 of the ECU 200. In the embodiment, the precondition is that the current sensors 71, 72, and 73 are normal.

For example, in the 3-phase motor 80 of Y connection, the current paths 81, 82, and 83 of the phases are connected to a neutral point P as a connection point of a closed circuit. According to the Kirchhoff law, the sum of currents flowing in and out of the connection point P of the closed circuit is zero. That is, the sensor signals Iu, Iv, and Iw of the three current sensors 71, 72, and 73 provided for the three current paths 81, 82, and 83, respectively, which are connected to the connection point P of the closed circuit satisfy the relation of "Iu + Iv + Iw = 0".

The ECU 200 includes the signal processing device 301 and the inverter control device 50, and operates on power supplied from the ECU power source 12 of about 12V. For example, the signal processing device 301 of the first embodiment has two AD converters 31 and 32 and an abnormality determination unit 40. Each of the abnormality determination unit 40 of the signal processing device 301 and the inverter control device 50 is configured by a microcomputer or the like and includes therein a CPU, a ROM, a RAM, and an I/O and a bus line or the like connecting the components which are not illustrated. The microcomputer executes controls by software process performed by executing a prestored program by the CPU and hardware process by a dedicated electronic circuit.

In the first embodiment, the two AD converters 31 and 32 are provided independently of each other, and at least one channel to which the sensor signals Iu, Iv, and Iw are input is provided. In the diagram, the first AD converter 31 is indicated as "ADC 1", and the second AD converter 32 is indicated as "ADC2". The AD converters 31 and 32 AD convert the sensor signals Iu, Iv, and Iw input from the current sensors 71, 72, and 73 and output the resultant signals as converted signals CIu1, CIv1, and CIw2.

In the fourth to sixth embodiments, the number of AD converters which are independent of one another is three. The number of channels to which the sensor signals Iu, Iv, and Iw are input, that is, the number of converted signals output from the channels in each of the AD converters varies among the embodiments.

The abnormality determination unit 40 determines an abnormality in the AD converters 31 and 32. The determining method will be described later. When the abnormality determination unit 40 determines that any of the AD converters 31 and 32 is abnormal, it transmits an abnormality signal to the inverter control device 50.

The inverter control device 50 obtains the converted signals Clu1, Clv1, and CIw2 of the phase currents from the signal processing device 301. To the inverter control device 50, a rotation angle θ of the motor 80 is input from a not-illustrated rotation angle sensor and a torque instruction Trq* is input from a higher-order vehicle control circuit. Based on those pieces of information, the inverter control device 50 controls, for example, the operation of the inverter 60 by current feedback control. When the abnormality signal is transmitted from the abnormality determination unit 40, the inverter control device 50 performs an abnormality-time process in accordance with the situation.

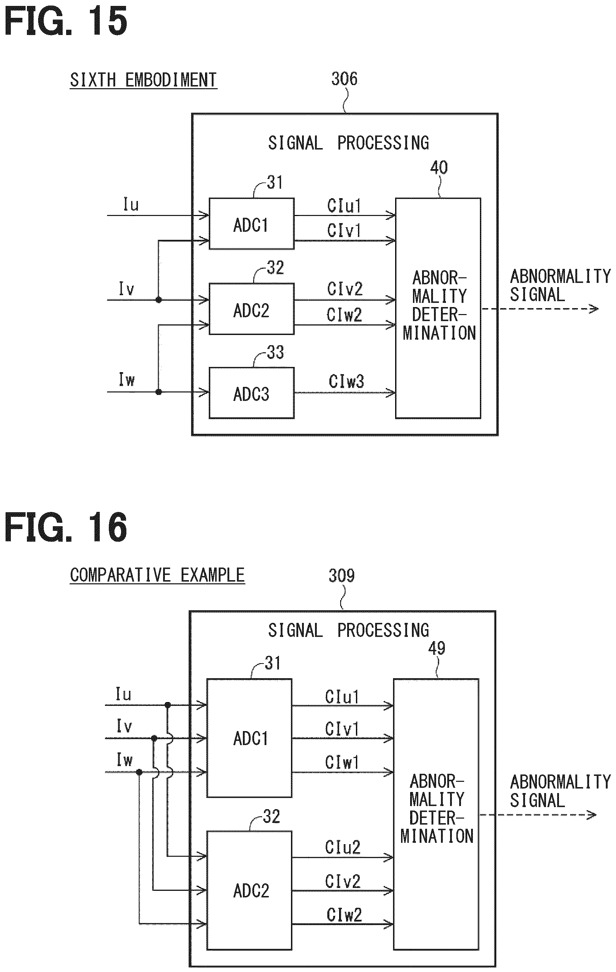

Regarding the abnormality determination of the AD converters, for example, the Patent Literature 1 (JP 2000-151405A) discloses a method of determining an abnormality by redundantly inputting the same analog signal to two independent AD converters and comparing digital data output from the AD converters. FIG. 16 illustrates, as a comparative example, a configuration in which the conventional technique is applied to a signal processing device to which the sensor signals Iu, Iv, and Iw of three-phase currents are input.

In a signal processing device 309 of the comparative example, the sensor signals Iu, Iv, and Iw of three phases are input to each of the two AD converters 31 and 32 each having three channels. The first AD converter 31 outputs converted signals Clu1, CIv1, and CIw1, and the second AD converter 32 outputs converted signals CIu2, CIv2, and CIw2.

An abnormality determination unit 40 of the comparative example compares the converted signals of the two AD converters 31 and 32 every sensor signal and, when the difference between the signals is larger than a determination threshold Dth, determines an abnormality. Specifically, when |CIu1-CIu2|>Dth, |CIv1-CIv2|>Dth, or |CIw1-CIw2|>Dth, it is determ ined that any of the two AD converters 31 and 32 is abnormal. The determination threshold Dth is set to a value which is substantially regarded as zero in consideration of variations in current detection and conversion.

In the signal processing device 309 of the comparative example, six channels are necessary as the total number of channels of the two AD converters 31 and 32. Generally, for N kinds of input signals, 2N channels are necessary as the total number of channels in the signal processing device 309 of the comparative example. The number of parts and the number of wirings increase.

An object in the signal processing device of the embodiment is to determine an abnormality of AD converters while reducing the total number of channels of the two or three AD converters. In the embodiment, as a main failure mode of the AD converters, a failure that a converted signal is fixed in one channel in any one of the AD converters during normal operation is assumed. For example, it is assumed that an abnormality that the power source of the AD converter is not turned on and the converted signals of all of the channels become zero is already detected at the stage of an initial check or the like. Hereinafter, each of the embodiments will be described.

### (First Embodiment)

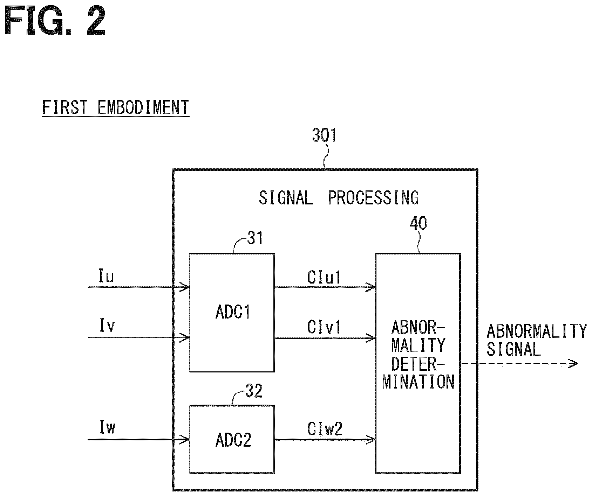

FIG. 2 schematically illustrates only a configuration related to determination of an abnormality in the AD converters 31 and 32 in the signal processing device 301 of the first embodiment. Different from FIG. 1, outputs of the converted signals Clu1, Clv1, and CIw2 from the AD converters 31 and 32 to the inverter control device 50 are not illustrated. The block diagrams of the signal processing devices of the second to sixth embodiments are according to FIG. 2.

When it is generalized, in the signal processing device, N kinds of sensor signals from N pieces of current sensors (N is an integer of three or larger) are input to total N to (2N - 1) channels of two to N pieces of AD converters. To each of the AD converters, at least one kind of sensor signal out of N kinds of sensor signals output from the current sensors is input. That is, there is no AD converter to which the sensor signal is not input.

In the first embodiment, sensor signals from N current sensors are input to total N channels of two AD converters. In the case where N = 3, sensor signals of the three current sensors 71, 72, and 73 are input to total three channels of the two AD converters 31 and 32.

In the example of FIG. 2, the first AD converter 31 has two channels to which the sensor signals are input, and the second AD converter 32 has one channel to which the sensor signal is input. In the two AD converters 31 and 32, the total number of channels to which the sensor signals are input is three, that is, N.

The first AD converter 31 receives the U-phase sensor signal Iu and the V-phase sensor signal Iv and outputs the converted signals Clu1 and Clv1. The second AD converter 32 receives the W-phase sensor signal Iw and outputs the converted signal CIw2. The three kinds of the sensor signals Iu, Iv, and Iw are separately input to the two AD converters 31 and 32 without being overlapped.

With respect to the converted signals output from the AD converters 31 and 32, the abnormality determination unit 40 calculates a "current sum value" as a sum of the three converted signals CIu1, CIv1, and CIw2 corresponding to currents flowing in and out of the connection point P. Particularly, in the embodiment, the currents detected by the current sensors 71, 72, and 73 are phase currents of the 3-phase motor, so that the value will be called a "phase current sum value". On the basis of the phase current sum value, the abnormality determination unit 40 determines an abnormality in the AD converters 31 and 32 by a logic which will be described later. The phase current sum value itself is a voltage signal.

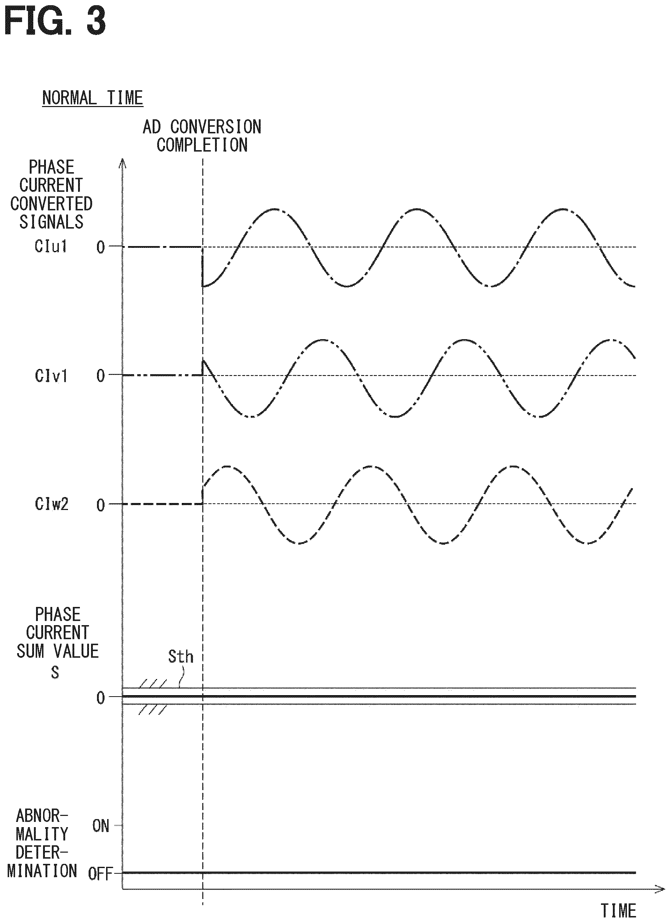

In the time charts of FIGS. 3 to 5, changes with time in the converted signals CIu1, CIv1, and CIw2, and the phase current sum value S are illustrated. At the normal time illustrated in FIG. 3, after completion of AD conversion, the sinusoidal-waveform converted signals CIu1, CIv1, and CIw2 whose phases are deviated from one another by 120 degrees are output. Strictly, the converted signal is a discrete value. However, it is assumed that the conversion cycle is sufficiently short for one electricity cycle, and the converted signal is illustrated by a continuous sinusoidal waveform.

As the phase current sum value S, a determination threshold Sth which is close to zero is set. The range of ± Sth corresponds to a range which is substantially regarded as zero in consideration of detection variations of the current sensors 71, 72, and 73 and variations of conversion of the AD converters 31 and 32. The absolute value |CIu1 + CIv1 + CIw2| of the phase current sum value S at the normal time is equal to or less than the determination threshold Sth, that is, is substantially zero according to the Kirchhoff law. The abnormality determination unit 40 determines that any of the two AD converters 31 and 32 is abnormal when the absolute value |CIu1 + CIv1 + CIw2| of the phase current sum value S is larger than the determination threshold Sth.

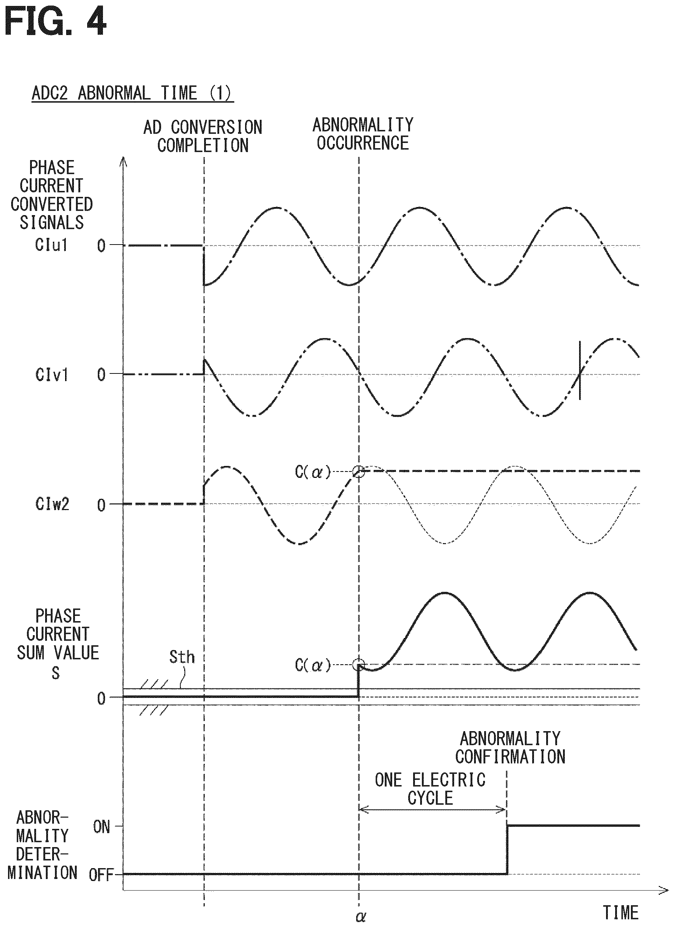

FIG. 4 illustrates the case where an abnormality occurs in the converted signal CIw2 due to a failure in the second AD converter 32. The thin dotted line indicates the converted signal CIw2 at the normal time. After occurrence of an abnormality, the converted signal CIw2 becomes constant at a value C(α) at abnormality occurrence time α as illustrated by the thick broken line. The phase current sum value S becomes a value obtained by adding C(α) to the sum of the two normal converted signals CIu1 and CIv1. Since the sum of the two normal converted signals CIu1 and CIv1 is equal to "-CIw2" obtained by changing the positive or negative sign of the converted signal CIw2 in the normal time, the phase current sum value S after the abnormality occurrence comes to have the sinusoidal waveform obtained by offsetting the sinusoidal waveform of the phase opposite to the phase of the converted signal CIw2 in the normal time. In the case where an abnormality occurs at the timing α around the peak of the converted signal CIv2, the absolute value |CIu1 + CIv1 + CIw2| of the phase current sum value S after the occurrence of the abnormality becomes always larger than the determination threshold Sth, so that the abnormality can be clearly determined.

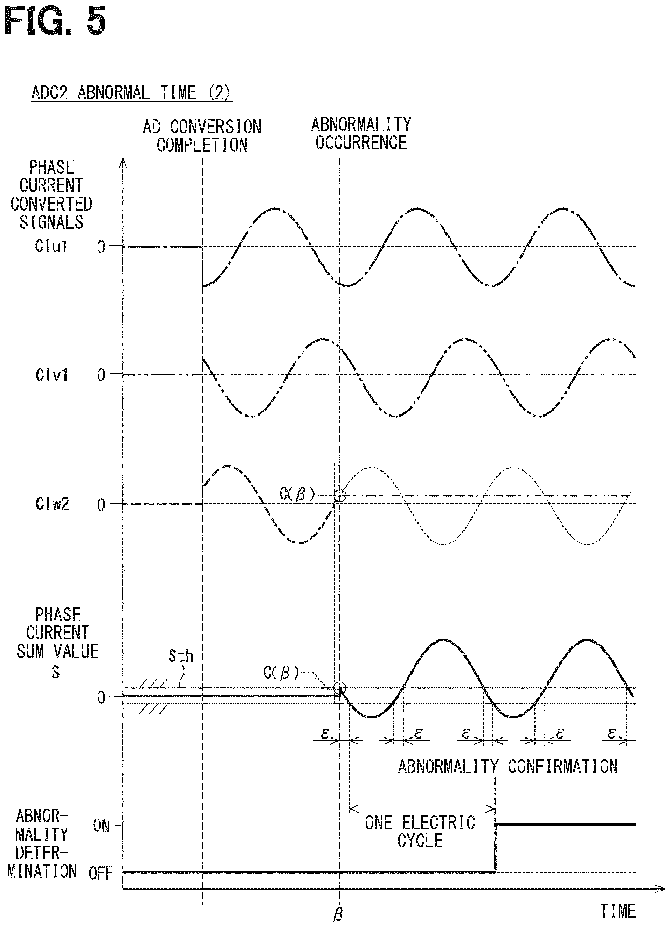

FIG. 5 illustrates the case where an abnormality occurs in the converted signal CIw2 due to a failure in the second AD converter 32 at a timing different from the timing in FIG. 4. In the case where an abnormality occurs at a timing β around the zero cross of the converted signal CIv2, that is, in the case where the value C(β) of the converted signal CIv2 at the abnormality occurrence time β is close to zero, the phase current sum value S after the occurrence of the abnormality fluctuates across zero. Then, periods ε in each of which the absolute value |CIu1 + CIv1 + CIw2| of the phase current sum value S becomes equal to or less than the determination value Sth occur in one electric cycle after the occurrence of the abnormality. The abnormality determination unit 40 calculates, for example, the phase current sum value S in a plurality of times in the period of one electric cycle after the absolute value |CIu1 + CIv1 + CIw2| of the phase current sum value S becomes larger than the determination threshold Sth. The abnormality determination unit 40 confirms the abnormality determination on the basis of a determination logic which will be described later.

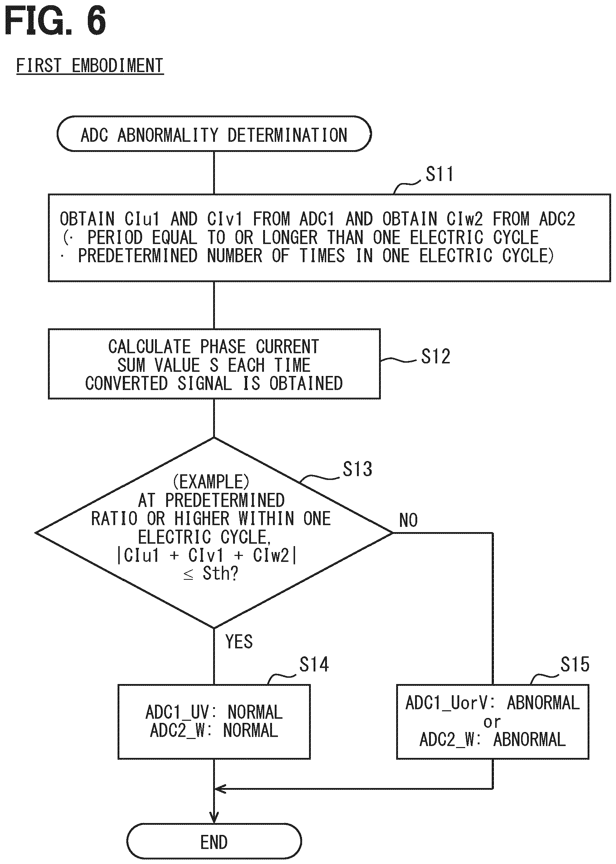

The flowchart of FIG. 6 illustrates AD converter abnormality determining process according to the first embodiment. The period and the number of times of obtaining the converted signal, and the determination logic are an example, and a determination logic other than this logic may be used. The sign "S" in the flowchart denotes a step. The flowchart of FIG. 6 also illustrates a program which operates the abnormality determination unit 40 so as to execute predetermined steps in the signal processing device 301. The flowcharts of the second and third embodiments are to be similarly interpreted.

In S11, the abnormality determination unit 40 obtains the converted signals CIu1 and CIv1 from the first AD converter 31 and obtains the converted signal CIw2 from the second AD converter 32. Each of the converted signals is obtained a predetermined number of times or more within one electric cycle over a period of the one electric cycle or longer. In S12, the abnormality determination unit 40 calculates the phase current sum value S each time the converted signals CIu1, CIv1, and CIw2 are obtained.

In S13, whether the absolute value |CIu1 + CIv1 + CIw2| of the phase current sum value S is equal to or less than the determination threshold Sth is determined. As described above, the determination threshold Sth is set to the upper limit value of the absolute value in the range which is substantially regarded as zero in consideration of variations in current detection and conversion.

As illustrated in FIG. 5, even when the converted signal CIw2 is abnormal, depending on an abnormality occurrence timing, a period in which the absolute value |CIu1 + CIv1 + CIw2| of the phase current sum value S is equal to or less than the determination value Sth is generated. Consequently, a determination logic for preventing an erroneous determination is necessary. For example, the abnormality determination unit 40 determines the number of times that the absolute value |CIu1 + CIv1 + CIw2| of the phase current sum value S becomes equal to or less than the determination threshold Sth is equal to or higher than a predetermined ratio in one electric cycle.

In another way, after noise is eliminated by performing filter process on the sensor signals Iu, Iv, and Iw, it is recognized that the maximum value and the minimum value in one electric cycle of each of the converted signals exceed thresholds, that is, sinusoidal variation occurs and, then, the absolute value of the phase current sum value S may be evaluated. The sinusoidal variation may be recognized on the basis of the time change rate of each of the converted signals. Depending on the determination logic, the abnormality confirmation can be made before lapse of one electric cycle since occurrence of an abnormality. It is assumed that the step of comparing the absolute value of the phase current sum value S and the determination threshold Sth in the flowchart of the second and third embodiments is executed on the precondition of such a determination logic.

In the case of YES in S13, in S14, it is determined that the Iu channel and the Iv channel of the first AD converter 31 and the Iw channel of the second AD converter 32 are normal. "ADC1_UV: normal" in S14 denotes that both the Iu channel and the Iv channel of the first AD converter 31 are normal. That is, in the case where a plurality of channels are normal, "and" in "U and V" is omitted.

In the case of NO in S13, in S15, it is determined that any of the Iu channel and the Iv channel of the first AD converter 31 and the Iw channel of the second AD converter 32 is abnormal. "ADC1_UorV: abnormal" in S15 denotes that either the Iu channel or the Iv channel of the first AD converter 31 is abnormal. That is, in the case where any of the plurality of channels is abnormal, "or" is written. The notation method of normal/abnormal in S14 and S15 will be applied to the flowcharts of the second and third embodiments.

As described above, the signal processing device 301 of the first embodiment can determine an abnormality in the AD converters 31 and 32 with the total three channels by using the fact that the Kirchhoff law is satisfied in the converted signals CIu1, CIv1, and CIv2 of the three-phase currents. That is, an abnormality in the AD converters 31 and 32 can be determined by the total number of channels smaller than that of the signal processing device 309 of the comparative example, and the number of parts and the number of wiring processes can be reduced.

Japanese Unexamined Patent Publication Number Hei 6-253585 (hereinafter, "reference literature") discloses an abnormal detection device detecting an abnormality on the basis of the sum of output values of current sensors of three phases, which detect currents of motor windings of three phases. However, the abnormality detection device of the reference literature is to detect an abnormality in the current sensors, and AD converters are not described.

On the other hand, the signal processing device of the embodiment has two or three AD converters provided independently of one another from the viewpoint of assuring reliability of the AD converters, and determines an abnormality in the AD converters on precondition that the current sensors are normal. In the case of simply using the technique of the reference literature for determination of an abnormality in an AD converter, one AD converter is sufficient. It is unnecessary to provide two or three AD converters independently of one another. The signal processing device of the embodiment is characterized by a point that, in a configuration having a plurality of AD converters, an abnormality of an AD converter is determined while reducing the total number of channels.

### (Second Embodiment)

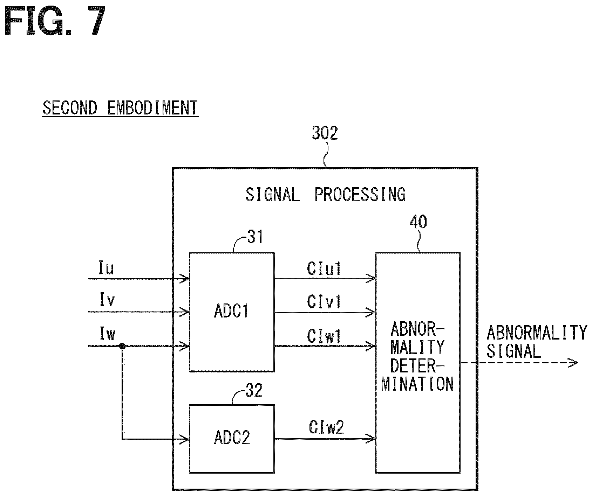

With reference to FIGS. 7 to 8, a signal processing device 302 of a second embodiment will be described. In a second embodiment, sensor signals from N current sensors are input to total (N+1) channels of two AD converters. In the case where N = 3, sensor signals of the three current sensors 71, 72, and 73 are input to total four channels of the two AD converters 31 and 32.

In the example of FIG. 7, the first AD converter 31 has three channels to which the sensor signals are input, and the second AD converter 32 has one channel to which the sensor signal is input. In the two AD converters 31 and 32, the total number of channels to which the sensor signals are input is four, that is, (N+1).

The first AD converter 31 receives the U-phase sensor signal Iu, the V-phase sensor signal Iv, and the W-phase sensor signal Iw, and outputs the converted signals CIu1, CIv1, and CIw1. The second AD converter 32 receives the W-phase sensor signal Iw and outputs the converted signal CIw2. That is, as one kind of the sensor signal, the W-phase sensor signal Iw is input commonly to the two AD converters.

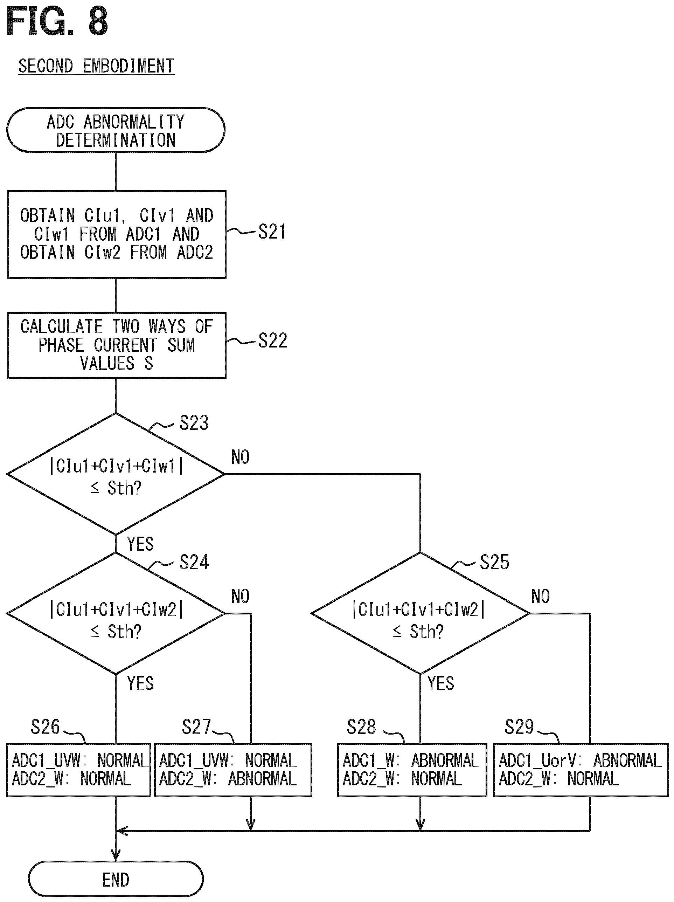

The flowchart of FIG. 8 illustrates an AD converter abnormality determining process according to the second embodiment. In S21, the abnormality determination unit 40 obtains the converted signals Clu1, Clv1, and Clw1 from the first AD converter 31, and obtains the converted signal CIw2 from the second AD converter 32. In S22, the abnormality determination unit 40 commonly uses the converted signals Clu1 and Clv1 of the U-phase and V-phase sensor signals Iu and Iv and calculates two ways of phase current sum values S by replacing only the converted signals CIw1 and CIw2 of the W-phase sensor signal Iw.

In S23, whether the absolute value |CIu1 + CIv1 + CIw1| of the phase current sum value S is equal to or less than the determination threshold Sth is determined. In the case of YES in S23, in S24, or in the case of NO in S23, in S25, whether the absolute value |CIu1 + CIv1 + CIw2| of the phase current sum value S is equal to or less than the determination threshold Sth is determined.

In the case of YES in S24, in S26, it is determined that all of the channels of the first and second AD converters 31 and 32 are normal. In the case of NO in S24, in S27, it is determined that all of the channels of the first AD converter 31 are normal, and the Iw channel in the second AD converter 32 is abnormal. In the case of YES in S25, in S28, it is determined that the Iw channel in the first AD converter 31 is abnormal, and the Iw channel in the second AD converter 32 is normal. It is not illustrated that, in the AD converter 31, the Iu channel and the Iv channel other than the Iw channel which is abnormal are normal.

In the case of NO in S25, the following is considered. When it is presumed that a failure can occur simultaneously in the two AD converters 31 and 32, the case is also assumed that the converted signals CIu1 and CIv1 commonly included in the phase current sum value S are normal and both of the converted signals CIw1 and CIw2 respectively added are abnormal. However, the probability that a failure occurs simultaneously in the two AD converters 31 and 32 is extremely low in reality and considered to be almost zero. Therefore, the abnormality determining process is based on the precondition that "an abnormality occurs only in one channel". It consequently comes to a conclusion that any one of the converted signals CIu1 and CIv1 commonly included in the phase current sum value S is abnormal.

Therefore, in the case of NO in S25, in S29, it is determined that either the Iu channel or the Iv channel of the first AD converter 31 is abnormal, and the Iw channel of the second AD converter 32 is normal. However, which one of the Iu channel and the Iv channel of the first AD converter 31 is abnormal cannot be specified.

In other words, in the case where the channel of the W-phase sensor signal Iw which is commonly input to the two AD converters is abnormal, which one of the Iw channel of the first AD converter 31 and the Iw channel of the second AD converter 32 is abnormal can be specified. In the case where the channels to which the sensor signals Iu and Iv which are not common are input are abnormal, at least it is an abnormality in the first AD converter 31 can be specified.

The narrowing of the range of abnormal channels by the abnormality determination unit 40 is expressed as "estimation of a channel of an AD converter which is abnormal". In the AD converter abnormality determining process according to the second embodiment, by comparing a plurality of phase current sum values S calculated by a plurality of combinations of converted signals, the channel of an AD converter which is abnormal can be estimated.

### (Third Embodiment)

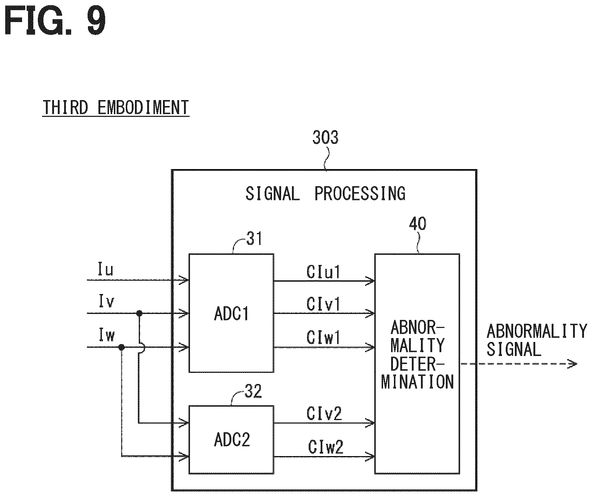

With reference to FIGS. 9 to 12, a signal processing device 303 of a third embodiment will be described. In the third embodiment, sensor signals of N current sensors are input to total (2N-1) channels of two AD converters. In the case where N = 3, sensor signals of the three current sensors 71, 72, and 73 are input to total five channels of the two AD converters 31 and 32.

In the example of FIG. 9, the first AD converter 31 has three channels to which the sensor signals are input, and the second AD converter 32 has two channel to which the sensor signal is input. In the two AD converters 31 and 32, the total number of channels to which the sensor signals are input is five, that is, (2N-1).

The first AD converter 31 receives the U-phase sensor signal Iu, the V-phase sensor signal Iv, and the W-phase sensor signal Iw, and outputs the converted signals CIu1, CIv1, and CIw1. The second AD converter 32 receives the V-phase sensor signal Iv and W sensor signal Iw, and outputs the converted signals CIv2 and CIw2. That is, two kinds of sensor signals which are the V-phase sensor signal Iv and the W-phase sensor signal Iw are commonly input to the two AD converters.

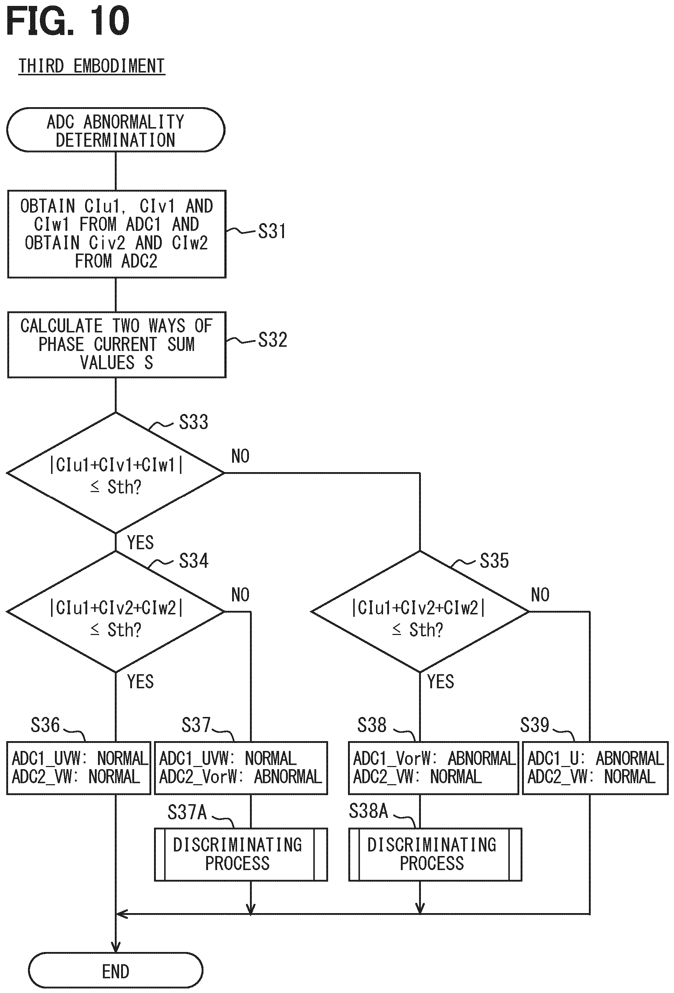

The flowchart of FIG. 10 illustrates AD converter abnormality determining process according to the third embodiment. In S31, the abnormality determination unit 40 obtains the converted signals CIu1, CIv1, and CIw1 from the first AD converter 31, and obtains the converted signals CIu2 and CIw2 from the second AD converter 32. In S32, the abnormality determination unit 40 calculates two ways of phase current sum values S by commonly using the converted signal CIu1 of the U-phase sensor signal Iu and replacing the converted signals CIv1 and CIv2 of the V-phase sensor signal Iv and the converted signals CIw1 and CIw2 of the W-phase sensor signal Iw.

In S33, whether the absolute value |CIu1 + CIv1 + CIw1| of the phase current sum value S is equal to or less than the determination threshold Sth is determined. In the case of YES in S33, in S34, or in the case of NO in S33, in S35, whether the absolute value |CIu1 + CIv2 + CIw2| of the phase current sum value S is equal to or less than the determination threshold Sth is determined.

In the case of YES in S34, in S36, it is determined that all of the channels of the first and second AD converters 31 and 32 are normal. In the case of NO in S34, in S37, it is determined that all of the channels of the first AD converter 31 are normal, and the Iv channel or the Iw channel of the second AD converter 32 is abnormal. After that, the program advances to discriminating process in S37A.

In the case of YES in S35, in S38, it is determined that the Iv channel or the Iw channel of the first AD converter 31 is abnormal, and the Iv channel and the Iw channel of the second AD converter 32 are normal. After that, the program advances to discriminating process in S38A. In the case of NO in S35, abnormality determination is performed on precondition that "an abnormality occurs only in one channel". Therefore, in the case of NO in S35, in S39, it is determined that the Iu channel of the first AD converter 31 is abnormal, and the Iv channel and the Iw channel of each of the AD converter 31 and the second AD converter 32 are normal.

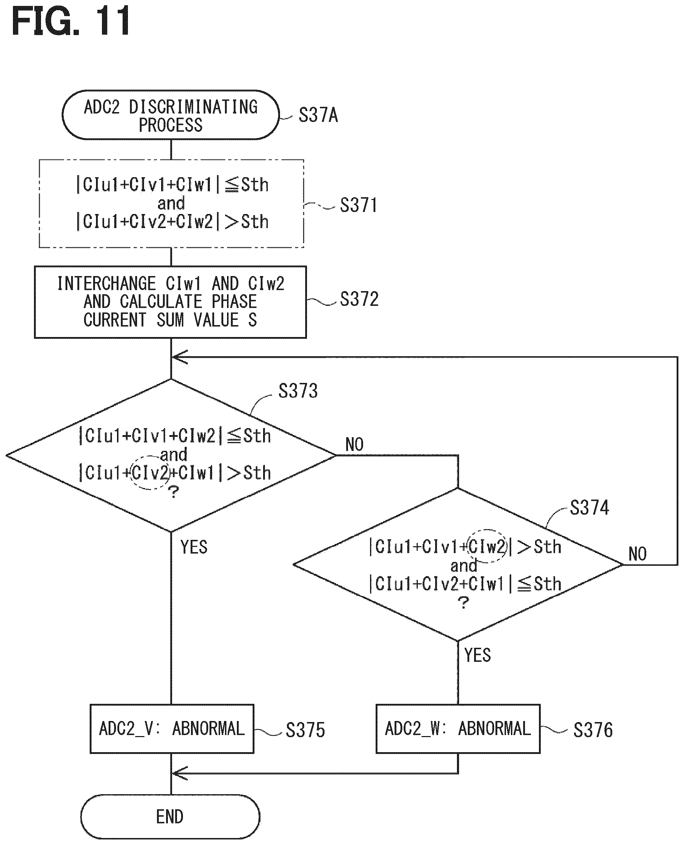

FIG. 11 illustrates a sub-flowchart of S37A. In S371, the result of YES in S33 and the result of NO in S34 are illustrated for confirmation. In S372, by interchanging the converted signals Cw1 and Cw2 in the two ways of the phase current sum values S in S371, further two ways of phase current cum values S are calculated.

In S373, whether the absolute value |CIu1 + CIv1 + CIw2| of the phase current sum value S is equal to or less than the determination threshold Sth and |CIu1 + CIv2 + CIw1| is larger than the determination threshold Sth is determined. In the case of NO in S373, in S374, on the contrary, whether the absolute value |CIu1 + CIv1 + CIw2| of the phase current sum value S is larger than the determination threshold Sth and |CIu1 + CIv2 + CIw1| is equal to or less than the determination threshold Sth is determined. In theory, YES is obtained in either S373 or S374, and NO is obtained in the other step.

In the case of YES in S373, it is considered that the converted signal CIv2 circled by the dash-double-dot line is abnormal. That is, it is determined that the Iv channel of the second AD converter 32 is anormal, and the Iw channel is normal. In the case of YES in S374, it is considered that the converted signal CIw2 circled by the dash-double-dot line is abnormal. That is, it is determined that the Iv channel of the second AD converter 32 is normal, and the Iw channel is abnormal. In such a manner, in the discriminating process of S37A, an abnormal channel in the second AD converter 32 is specified. It is also possible to use a logic which performs the determination by calculating four ways of phase current sum values S from the beginning, not executing the main flow of FIG. 10 and the discriminating process of FIG. 11 at two stages.

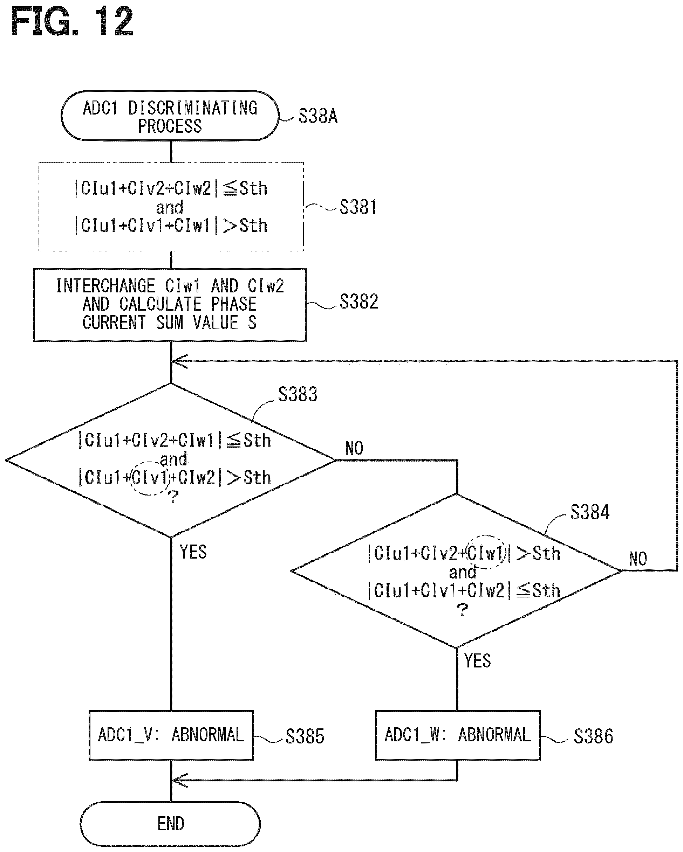

FIG. 12 illustrates a sub flowchart of the discriminating process in S38A. Since S381 to S386 are similar to S371 to S376 in FIG. 11, the description will not be repeated. In the discriminating process in S38A, an abnormal channel which is either the Iv channel or the Iw channel in the first AD converter 31 is specified.

In the AD converter abnormality determining process according to the third embodiment, by comparing a plurality of phase current sum values S calculated by a plurality of combinations of converted signals, an abnormal channel in an AD converter is estimated, and an abnormality in all of five channels can be specified.

### (Fourth, Fifth and Sixth Embodiments)

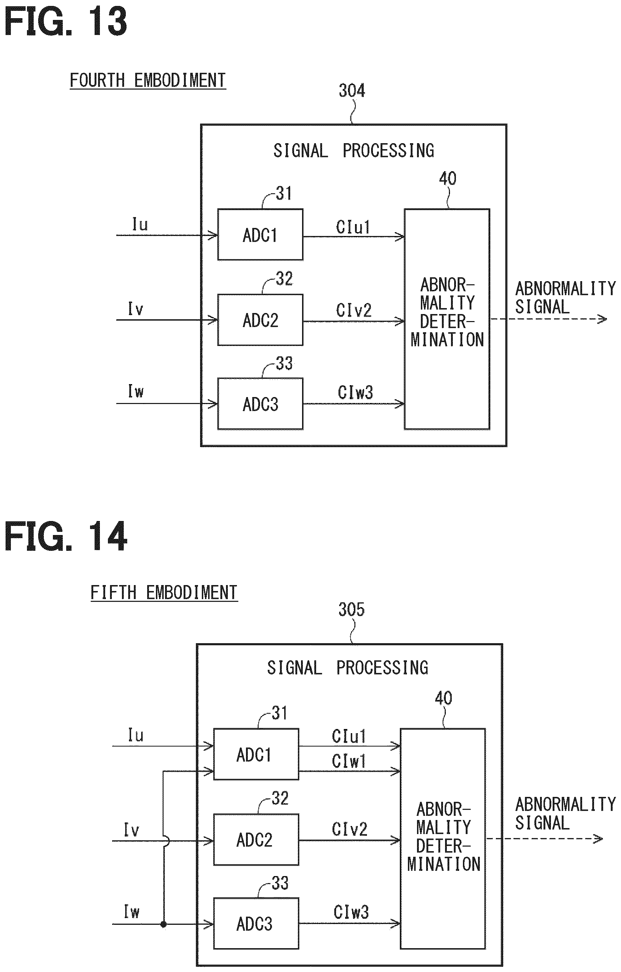

Referring now to FIGS. 13 to 15, fourth to sixth embodiments in which the signal processing device have three AD converters 31, 32, and 33 of which number is equal to the number of current sensors 71, 72, and 73 will be described. In the diagram, the third AD converter 33 is indicated as "ADC3". In the fourth to sixth embodiments, sensor signals of N current sensors are input to total N to (2N-1) channels of N AD converters. In the case where N = 3, sensor signals from the three current sensors 71, 72, and 73 are input to total three to five channels of the three AD converters 31, 32, and 33.

In the fourth to sixth embodiments, total N sensor signals made of N kinds are respectively input to N AD converters. In the case where N = 3, total three sensor signals Iu, Iv, and Iw made of three kinds are respectively input to the three AD converters 31, 32, and 33.

In a signal processing device 304 of the fourth embodiment illustrated in FIG. 13, each of the first AD converter 31, the second AD converter 32, and the third AD converter 33 has one channel to which a sensor signal is input. In the three AD converters 31, 32, and 33, the total number of channels to which sensor signals are input is three, that is, N.

The first AD converter 31 receives the U-phase sensor signal Iu, and outputs the converted signal Clu1. The second AD converter 32 receives the V-phase sensor signal Iv, and outputs the converted signals CIv2. The third AD converter 33 receives the W-phase sensor signal Iw and outputs the converted signal CIw3. The three kinds of the sensor signals Iu, Iv, and Iw are separately input to the three AD converters 31, 32 and 33 without being overlapped.

The abnormality determination unit 40 determines that any of the three AD converters 31, 32 and 33 is abnormal when the absolute value |CIu1 + CIv2 + CIw3| of the phase current sum value S is larger than the determination threshold Sth. Which one of the AD converters is abnormal cannot be specified.

In the signal processing device 301 of the first embodiment, the first AD converter 31 sequentially AD converts the U-phase sensor signal Iu and the V-phase sensor signal Iv which are input. Since AD conversion cannot be performed at the same time, a sample and hold circuit and a multiplexer circuit are necessary in the AD converter. On the other hand, in the signal processing device 304 of the fourth embodiment, the sensor signals Iu, Iv, and Iw of three phases can be AD converted by the three AD converters 31, 32, and 33 at the same time. Consequently, the configuration in the AD converter is simple, and abnormality detection time can be shortened.

A signal processing device 305 of a fifth embodiment illustrated in FIG. 14 is obtained by combining the fourth and second embodiments. The first AD converter 31 has two channels to which sensor signals are input, and each of the second and third AD converters 32 and 33 has one channel to which a sensor signal is input. In the three AD converters 31, 32 and 33 the total number of channels to which the sensor signals are input is four, that is, (N+1).

The first AD converter 31 receives the U-phase sensor signal Iu and the W-phase sensor signal Iw, and outputs the converted signals Clu1 and Clw1. The second AD converter 32 receives the V-phase sensor signal Iv, and outputs the converted signals CIv2. The third AD converter 33 receives the W-phase sensor signal Iw and outputs the converted signal CIw3. That is, the W-phase sensor signal Iw is input commonly to the two AD converters. Since the same kind of the sensor signals are not input to the same AD converter, the second W-phase sensor signal Iw is input to any of the two AD converters other than the AD converter to which the first W-phase sensor signal Iw is input.

Based on the absolute values |CIu1 + CIv2 + CIw3| and |CIu1 + CIv2 + CIw1| of two ways of the phase current sum values S, the abnormality determination unit 40 determines the presence/absence of an abnormality. When one or both of the absolute values of the phase current sum values S is/are larger than the determination threshold Sth, the abnormality determination unit 40 determines whether the channel of each AD converter is normal or abnormal by a process similar to that of FIG. 8. Therefore, in the fifth embodiment, in addition to shortening of the abnormality detection time, an abnormal channel in an AD converter can be estimated.

A signal processing device 306 of a sixth embodiment illustrated in FIG. 15 is obtained by combining the fourth and third embodiments. Each of the first and second AD converters 31 and 32 has two channels to which sensor signals are input, and the third AD converter 33 has one channel to which a sensor signal is input. In the three AD converters 31, 32 and 33, the total number of channels to which the sensor signals are input is five, that is, (2N-1).

The first AD converter 31 receives the U-phase sensor signal Iu and the V-phase sensor signal Iv and outputs the converted signals Clu1 and Clv1. The second AD converter 32 receives the V-phase sensor signal Iv and W-phase sensor signal Iw, and outputs the converted signals CIv2 and CIw2. The third AD converter 33 receives the W-phase sensor signal Iw and outputs the converted signal CIw3. That is, the V-phase sensor signal Iv and the W-phase sensor signal Iw are commonly input to the two AD converters.

For example, based on two ways of the absolute values |CIu1 + CIv2 + CIw3| and |CIu1 + CIv1 + CIw2| of the phase current sum value S, the abnormality determination unit 40 determines the presence/absence of an abnormality. When one or both of the absolute values of phase current sum value S is/are larger than the determination threshold Sth, the abnormality determination unit 40 determines whether the channel of each AD converter is normal/abnormal by process similar to those in FIGS. 10 to 12. Therefore, in the sixth embodiment, in addition to shortening of the abnormality detection time, an abnormal channel in an AD converter can be specified.

### (Other Embodiments)

(a) When the current sensors are provided for phase current paths of a multi-phase motor, the current sensors may be provided for phase current paths of not only a three-phase motor but also a motor of four or more phases. In the case of an N-phase motor (N is an integer of three or larger), N current paths are connected to a connection point of a closed circuit. For example, in the case where N = 4, the total number of channels to which sensor signals are input is four, five, six, or seven. The signal processing device of the present disclosure can be applied not only to a motor drive system but also to a general system having a connection point of a closed circuit to which the Kirchhoff law can be applied.
(b) In the configurations illustrated in the diagrams of the embodiments, by interchanging the three phases of the sensor signals and the order of the two or three AD converters, a plurality of ways of uniform configurations can be obtained. For example, in the first embodiment, one of the two AD converters 31 and 32 has one channel, and any of the sensor signals Iu, Iv, and Iw of three phases is input to the one channel, so that there are six ways of configurations. In each of the second and third embodiments, there are also six ways.

In the fourth embodiment, by the permutation of three phases, there are ₃P₃=6 ways. In the fifth embodiment, a sensor signal of one phase is input so as to be overlapped for each of the patterns of the fourth embodiment. Since the case that the sensor signal of the same kind is input to the same AD converter is excluded, the second sensor signal overlapped is input to any of two AD converters other than the AC converter to which the first sensor signal is input. Therefore, there are 6×3×2 = 36 ways. In the sixth embodiment, two kinds of sensor signals are input to two AD converters out of the three AD converters 31, 32, or 33, and one kind of a sensor signal is input to one AD converter. Although the calculating method is omitted, there are 72 ways.

The present disclosure is not limited to the above embodiments but various modifications may be made further within the scope of the present disclosure without departing from the spirit of the disclosure.

The abnormality determination unit and the method thereof of the present disclosure may be implemented by a dedicated computer provided by configuring a processor and a memory programmed to execute one or more functions embodied by a computer program. Alternatively, the abnormality determination unit and the method described in the present disclosure may be implemented by a dedicated computer provided by forming a processor with one or more dedicated hardware logic circuits. Alternatively, the abnormality determination unit and the method described in the present disclosure may be implemented by one or more dedicated computers including a combination of a processor and a memory programmed to execute one or multiple functions and a processor including one or more hardware logic circuits. The computer program may also be stored on a computer-readable and non-transitory tangible storage medium as an instruction executed by a computer.

The present disclosure has been made in accordance with the embodiments. However, the present disclosure is not limited to such embodiments and configurations. The present disclosure also encompasses various modifications and variations within the scope of equivalents. Furthermore, various combination and formation, and other combination and formation including one, more than one or less than one element may be made in the present disclosure.

## Claims

1. A signal processing device for analog-to-digital converting a plurality of sensor signals input from current sensors (71, 72, 73) provided for N pieces (N denotes an integer of three or more) of current paths (81, 82, 83) connected to a connection point (P) of a closed circuit, and outputting resultant signals as converted signals, the signal processing device comprising:
two to N pieces of AD converters (31, 32, 33) provided independently of one another and each having at least one channel to which the sensor signal is input; and
an abnormality determination unit (40) calculating a current sum value as a sum of the N pieces of the converted signals corresponding to currents flowing in and out of the connection point with respect to the converted signals output from the AD converters and, when an absolute value of the current sum value is greater than a determination threshold, determining that any of channels of any of the AD converters is abnormal,
wherein
in the two to N pieces of the AD converters, a total number of channels to which the sensor signal is input is N to (2N-1), and
at least one kind of the sensor signal out of N kinds of the sensor signals output from the current sensors is input to each of the AD converters.

2. The signal processing device according to claim 1, wherein
in the two to N pieces of the AD converters, the total number of channels to which the sensor signals are input is N, and
N kinds of the sensor signals are respectively input to two or more pieces of the AD converters without being overlapped.

3. The signal processing device according to claim 1, wherein
in the two to N pieces of the AD converters, the total number of channels to which the sensor signals are input is (N+1) to (2N-1), and at least one kind of the sensor signal is commonly input to two or more pieces of the AD converters, and
the abnormality determination unit compares a plurality of current sum values calculated by a plurality of combinations of the converted signals, and estimates a channel in the AD converter which is abnormal.

4. The signal processing device according to claim 2 or 3, comprising
N pieces of the AD converters,
wherein
total N pieces of the sensor signals of N kinds, respectively, are input to the N pieces of the AD converters, respectively.

5. The signal processing device according to any one of claims 1 to 4, wherein
the signal processing device is applied to a motor drive system (90) passing multi-phase alternate current from an inverter (60) to a motor (80) to drive the motor, and
the current sensor detects a phase current passed to a current path connected to any of phase windings of the motor.

6. A program for a signal processing device for analog-to-digital converting a plurality of sensor signals input from current sensors (71, 72, 73) respectively provided for N pieces (N denotes an integer of three or more) of current paths (81, 82, 83) connected to a connection point (P) of a closed circuit, and outputting resultant signals as converted signals,
wherein the signal processing device comprises:
two to N pieces of AD converters (31, 32, 33) provided independently of one another and each having at least one channel to which the sensor signal is input,
in the two to N pieces of the AD converters, a total number of channels to which the sensor signal is input is N to (2N-1),
at least one kind of the sensor signal out of N kinds of sensor signals output from the current sensors is input to each of the AD converters, and
the program causes the signal processing device to
calculate a current sum value as a sum of the N pieces of the converted signals corresponding to currents flowing in and out of the connection point with respect to the converted signals output from the AD converters and, when an absolute value of the current sum value is greater than a determination threshold, determine that any of channels of any of the AD converters is abnormal.
